# EUROPEAN PATENT APPLICATION

(11) **EP 4 390 537 A2**
(43) Date of publication of application: **26.06.2024**
(21) Application number: 23215386.6
(22) Date of filing: 08.12.2023
(51) Int. Cl.: G03F 1/24

(54) **REFLECTIVE MASK BLANK**

(30) Priority: 21.12.2022 JP 2022204297
(71) Applicant: Shin-Etsu Chemical Co., Ltd., Tokyo (JP)
(72) Inventor: KOSAKA, Takuro, Joetsu-shi (JP); OGOSE, Taiga, Joetsu-shi (JP)
(74) Representative: Mewburn Ellis LLP

(57) **Abstract**

A reflective mask blank which is a material for a reflective mask used in EUV lithography in which EUV light is exposure light, including a substrate, a reflective multilayer film that is formed on one main surface of the substrate, has a periodically laminated structure in which layers having a comparatively low refractive index with respect to exposure light and layers having a comparatively high refractive index with respect to the exposure light are alternately laminated, and reflects the exposure light, a protection film that is formed in contact with the reflective multilayer film, and an absorber film that is formed in contact with the protection film, absorbs the exposure light, and has a film stress of not more than a film stress in the case of forming the absorber film directly on the substrate.

## Description

### TECHNICAL FIELD

The present invention relates to a reflective mask blank which is a material for a reflective mask used in manufacturing semiconductor devices such as LSIs.

### BACKGROUND

In a manufacturing process of a semiconductor device, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form a further fine pattern under continuous miniaturization of device patterns, an extreme ultraviolet lithography technique using, as exposure light, extreme ultraviolet (here after refers to as "EUV") light having a shorter wavelength than the wavelength of ArF excimer laser light has been used. The EUV light is light having a wavelength of about 0.2 to 100 nm, in particular, light having a wavelength of around 13.5 nm. The EUV light has a very low transparency to a substance and cannot be utilized for a conventional transmissive projection optical system or a mask, thus, a reflection type optical elemental device is applied. Therefore, a reflective mask is also proposed as a mask for the pattern transfer.

In the reflective mask, commonly, a reflective multilayer film that reflects EUV light is formed on one main surface of a low thermal expansion substrate made of glass, and further an absorber film formed in a pattern that absorbs EUV light is formed on the reflective multilayer film. On the other hand, a material (including also a material in which a resist layer is formed) before patterning the absorber film is called a reflective mask blank, and is used as a material for the reflective mask. In the reflective mask blank, a reflective multilayer film that reflects EUV light is formed on one main surface of a low thermal expansion substrate made of glass, and further an absorber film that absorbs EUV light is formed on the reflective multilayer film. The reflective mask blank has a basic structure including a reflective multilayer film and an absorber film.

As the reflective multilayer film, a Mo/Si reflective multilayer film in which molybdenum (Mo) layers and silicon (Si) layers are alternately laminated to ensure a reflectance for EUV light is commonly used. As the absorber film, a material containing tantalum (Ta), as a main component, which has a relatively large extinction coefficient with respect to EUV light, is used (Patent Document 1: JP-A 2002-246299). On the other hand, a back-surface conductive film such as a metal film is formed on the other main surface of the substrate for electrostatic chucking in holding the reflective mask in an exposure apparatus. As the back-surface conductive film, a film containing manly chromium (Cr) or tantalum (Ta) is used.

Further, a protection film for protecting the reflective multilayer film is commonly formed between the reflective multilayer film and the absorber film. The protection film is formed to protect the reflective multilayer film when the reflective mask blank is exposed to etching gas during etching to form a mask pattern in the absorber film, or exposed to cleaning liquid during cleaning after forming the mask pattern. Further, the protection film is formed so that the reflective multilayer film is not be damaged in pattern correction processing when a defect is detected after forming the mask pattern. As a material for the protection film, for example, ruthenium (Ru) is used (Patent Document 2: JP-A 2002-122981). When the protection film is required to have function of suppressing decrease in reflectance of the reflective multilayer film in EUV light exposure, use of a material including ruthenium (Ru) added with niobium (Nb), rhodium (Rh), zirconium (Zr), or others has been proposed.

### Citation List

Patent Document 1: JP-A 2002-246299
Patent Document 2: JP-A 2002-122981

### SUMMARY OF THE INVENTION

In manufacturing step of a reflective mask blank, after forming a reflective multilayer film, and then forming reference marks for defect coordinate position, ABI (Actinic Blank Inspection) using EUV light is performed to detect defects called phase defect. When a reflective mask is processed, so-called mitigation (defect mitigation) is performed so as not to be caused defect transfer in pattern drawing process of the reflective mask based on information of the defect coordinate position in the ABI inspection, and finally, prescribed pattern is formed in an absorber film. From the viewpoints of preventing misalignment in the mitigation and change in shape of a substrate after patterning, film stress of the absorber film must be controlled as low as possible.

Since a part of the absorber film of the reflective mask blank is removed to form a pattern, if the film stress is large, an amount of warpage of the substrate changes due to pattern formation. Therefore, in order to maintain positional accuracy of the pattern, it is preferable that the film stress is small. However, in addition to film stress, the absorber film is required that: the absorber film must have a sufficiently low reflectance at a prescribed thickness; the absorber film has film qualities of microcrystalline structure and low surface roughness to control LER (Line Edge Roughness) of the pattern low; the absorber film has a high etching rate to ensure processability; and sheet resistance is suppressed to not more than 10⁷ Ω/square so as not to cause charge of the substrate in EB (Electron Beam) drawing. The film stress of the absorber film can be adjusted to a certain extent by changing film forming conditions, however if the film forming conditions are changed, not only the film stress but also properties other than the film stress, such as film quality, change significantly. Particularly, it is difficult to reduce the film stress in the case of a film having a high degree of nitridation, since the film stress cannot be adjusted simply by changing the film forming conditions.

The present invention has been made to solve the above problems, and an object of the present invention is to provide a reflective mask blank that includes an absorber film having a low film stress, particularly, an absorber film having a low film stress with ensuring properties necessary for the absorber film.

The inventors have made earnestly studies to solve the above problems. As a result, the inventors found, in a protection film that is in contact with an absorber film and is formed of a material consists of ruthenium (Ru), niobium (Nb) and oxygen (O), the protection film having a composition containing ruthenium (Ru) and being free of oxygen (O), at the side close to a reflective multilayer film, and a composition consisting of ruthenium (Ru), niobium (Nb) and oxygen (O), or niobium (Nb) and oxygen (O), at the side in contact with the absorber film. Further, the inventors found that, by forming the absorber film in contact with the protection film, it can be provided a reflective mask blank that includes an absorber film having a low film stress with ensuring properties necessary for the absorber film, particularly, an absorber film formed in contact with the protection film that have a film stress of not more than a film stress in the case of forming the absorber film directly on the substrate.

In one aspect, the invention provides a reflective mask blank which is a material for a reflective mask used in EUV lithography in which EUV light is exposure light, including
a substrate,
a reflective multilayer film that is formed on one main surface of the substrate, has a periodically laminated structure in which layers having a comparatively low refractive index with respect to exposure light and layers having a comparatively high refractive index with respect to the exposure light are alternately laminated, and reflects the exposure light,
a protection film that is formed in contact with the reflective multilayer film, and
an absorber film that is formed in contact with the protection film, and absorbs the exposure light, wherein
the absorber film has a film stress of not more than a film stress in the case of forming the absorber film directly on the substrate.

Preferably, the protection film consists of ruthenium (Ru), niobium (Nb) and oxygen (O), has a composition at the side close to the reflective multilayer film that includes ruthenium (Ru) and is free of oxygen (O), and has a composition at the side in contact with the absorber film that consists of ruthenium (Ru), niobium (Nb) and oxygen (O), or niobium (Nb) and oxygen (O).

Preferably, the protection film has a composition at the side close to the reflective multilayer film that consists of ruthenium (Ru), or ruthenium (Ru) and niobium (Nb).

Preferably, in the protection film, the composition at the side close to the reflective multilayer film has a niobium (Nb) content of not more than 60 at%.

Preferably, the protection film has a niobium (Nb) content that stepwise and/or continuously increases along the thickness direction from the side close to the reflective multilayer film to the side in contact with the absorber film.

Preferably, in the protection film, the composition at the side close to the absorber film has a total content of niobium (Nb) and oxygen (O) of not less than 60 at%.

Preferably, the protection film has an oxygen (O) content that stepwise and/or continuously increases along the thickness direction from the side close to the reflective multilayer film to the side in contact with the absorber film.

Preferably, the protection film includes a stress relaxing layer formed in contact with the absorber film.

Preferably, the protection film consists of two layers of
(A) a layer that has a composition including ruthenium (Ru), and being free of oxygen (O), and is close to the reflective multilayer film, and
(B) a layer that has a composition consisting of ruthenium (Ru), niobium (Nb) and oxygen (O), or niobium (Nb) and oxygen (O), and is in contact with the absorber film.

Preferably, the layer (A) consists of ruthenium (Ru), or ruthenium (Ru) and niobium (Nb).

Preferably, the layer (A) has a composition at the side close to the reflective multilayer film that has a content of niobium (Nb) of not more than 60 at%.

Preferably, the layer (A) has two or more of sublayers that have different compositions each other, or is a compositionally graded layer, and
the layer (A) has a niobium (Nb) content that stepwise and/or continuously increases along the thickness direction from the side close to the reflective multilayer film to the side in contact with the layer (B).

Preferably, the layer (B) has a composition at the side close to the absorber film has a total content of niobium (Nb) and oxygen (O) of not less than 60 at%.

Preferably, the layer (B) has two or more of sublayers that have different compositions each other, or is a compositionally graded layer, and
the layer (B) has an oxygen (O) content that stepwise and/or continuously increases along the thickness direction from the side in contact with the layer (A) to the side in contact with the absorber film.

Preferably, the protection film has a thickness of not less than 2 nm and not more than 5 nm, and
the layer (B) has a thickness of not less than 10% and not more than 50% of the thickness of the protection film.

Preferably, the absorber film includes tantalum (Ta) and nitrogen (N).

Preferably, the absorber film further includes one or more additive elements selected from the group consisting of hydrogen (H), boron (B), carbon (C), silicon (Si), molybdenum (Mo), zirconium (Zr), chromium (Cr), germanium (Ge) and aluminum (Al), and has a total content of the additive element(s) of not more than 20 at%.

Preferably, the absorber film has a thickness of not less than 50 nm and not more than 80 nm,
the absorber film consists of a single layer consisting of tantalum (Ta) and nitrogen (N), or consists of a substrate-side layer consisting of tantalum (Ta) and nitrogen (N) and a surface-side layer consisting of tantalum (Ta), nitrogen (N) and oxygen (O),
each of the single layer, the substrate-side layer and the surface layer has a ratio Ta/N of tantalum (Ta) and nitrogen (N) of 55/45 to 65/35,
the surface-side layer has an oxygen (O) content of not less than 20 at% and not more than 40 at% at the side remotest from the substrate, and
the surface-side layer has a thickness of not more than 2 nm.

### ADVANTAGEOUS EFFECTS

According to the invention, a reflective mask blank that includes an absorber film having a low film stress with ensuring properties necessary for the absorber film can be provided.

### BRIEF DESCRIPTION OF THE DRAWINGS

FIG. 1 is a cross-sectional view illustrating an example of first embodiment of a reflective mask blank of the invention.
FIG. 2 is a cross-sectional view illustrating an example of second embodiment of a reflective mask blank of the invention.
FIG. 3 is a cross-sectional view illustrating an example of third embodiment of a reflective mask blank of the invention.

### FURTHER EXPLANATIONS; OPTIONS AND PREFERENCES

A reflective mask of the invention is used in EUV lithography utilizing EUV light as exposure light. A reflective mask blank of the invention is a material for the reflective mask. A wavelength of EUV light used in EUV lithography utilizing EUV light as exposure light is 13 to 14 nm, normally about 13.5 nm (for example, 13.4 to 13.6 nm). A reflective mask blank and a reflective mask using EUV light as exposure light are also called an EUV mask blank and an EUV mask, respectively.

The reflective mask blank of the invention includes a substrate, a reflective multilayer film that is formed on (at the upper side of) one main surface (front surface) of the substrate, and reflects exposure light, a protection film that is formed in contact with the reflective multilayer film, and an absorber film that is formed in contact with the protection film, and absorbs the exposure light (reduces reflectance of the exposure light). The reflective multilayer film is preferably formed in contact with the one main surface of the substrate, however, another film such as an underlayer may be formed between the one main surface of the substrate and the reflective multilayer film.

In the invention, for the sake of convenience, one main surface of the substrate is defined as the front surface and the upper side, and the other main surface on which a back-surface conductive film (described later) may be provided is defined as the back surface and the lower side. The one main surface and the other main surface are either of the two main surfaces (film forming surfaces) of the substrate, and the front and the back, and the upper side and the lower side are, respectively, replaceable.

For EUV light exposure, the substrate preferably has low thermal expansion property. For example, the substrate is preferably composed of a material having a coefficient of thermal expansion within preferably ±2×10⁻⁸/°C, more preferably ±5×10⁻⁹/°C. As such a material, for example, a SiO₂-TiO₂-based glass in which titania is doped is used. Further, a substrate having a sufficiently flatted surface is preferably used. The main surface of the substrate has a surface roughness, as an RMS value, of preferably not more than 0.5 nm, more preferably not more than 0.2 nm. Such a surface roughness can be obtained by polishing the substrate. For the substrate, for example, a substrate having dimensions of 6 inches square and 0.25 inches thick, which is so-called a 6025 substrate defined in SEMI standard, is suitable. The 6025 substrate is usually expressed as a 152 mm-square and 6.35 mm-thick substrate using the SI unit.

The reflective multilayer film has a periodically laminated structure in which layers having a comparatively low refractive index with respect to exposure light (layers composed of a material having a comparatively low refractive index with respect to exposure light (a low refractive index material)), and layers having a comparatively high refractive index with respect to the exposure light (layers composed of a material having a comparatively high refractive index with respect to exposure light (a high refractive index material)) are alternately laminated. As the periodically laminated structure, a Si/Mo periodically laminated structure in which layers composed of silicon (Si) corresponding to the material having a comparatively high refractive index with respect to exposure light (Si layers), and layers composed of molybdenum (Mo) corresponding to the material having a comparatively low refractive index with respect to exposure light (Mo layers) are alternately laminated is exemplified.

The Si layer and the Mo layer are preferably layers formed of, respectively, simple Si and simple Mo, however, may contain one or more other elements as long as they are less than 10 at%. The number of stacked Si layers and Mo layers is preferably not less than 40 cycles (not less than 40 layers, respectively), and not more than 60 cycles (not more than 60 layers, respectively).

Thicknesses of the Si layer and the Mo layer are appropriately set according to the exposure wavelength, and the thickness of the Si layer is preferably not more than 5 nm, and the thickness of the Mo layer is preferably not more than 4 nm. The lower limit of the thicknesses of the Si layer and the Mo layer is normally not less than 1 nm, however, not particularly limited thereto. The thicknesses of the Si layer and the Mo layer may be set so as to obtain a high reflectance to exposure light. Further, the thickness of each Si layer and the thickness of each Mo layer may be constant or may vary in respective layers. An overall thickness of the Si/Mo periodically laminated structure (a thickness of the reflective multilayer film when the reflective multilayer film consists of only the Si/Mo periodically laminated structure) is normally about 250 to 450 nm.

In the Si/Mo periodically laminated structure, a layer containing silicon (Si) and nitrogen (N) may be formed in contact with both of the Si layer and the Mo layer, at least one between the Si layer and the Mo layer. The layer containing silicon (Si) and nitrogen (N) is preferably free of oxygen (O). The layer containing silicon (Si) and nitrogen (N) is preferably a SiN layer. In the SiN layer, "SiN" represents that the constituent elements are silicon (Si) and nitrogen (N), and does not represent the composition ratio. The layer containing silicon (Si) and nitrogen (N) has a nitrogen (N) content of preferably not less than 1 at%, more preferably not less than 5 at%, and preferably not more than 60 at%, more preferably not more than 57 at %. Further, the layer containing silicon (Si) and nitrogen (N) has a thickness of preferably not more than 2 nm, more preferably not more than 1 nm. The layer containing silicon (Si) and nitrogen (N) preferably has a lower limit of the thickness of not less than 0.1 nm, however not particularly limited thereto.

Examples of methods for forming the reflective multilayer film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. The sputtering method is a film forming method that utilizes sputtering phenomenon by gas ions generated by applying a voltage to a target with feeding a sputtering gas into a chamber to ionize the gas. Particularly, a magnetron sputtering method has an advantage in productivity. The power may be applied to the target by a DC system or an RF system. The DC system includes also a pulse sputtering in which a negative bias applied to the target is inverted for a short time to prevent charge-up of the target.

The Si/Mo periodically laminated structure portion may be formed by, for example, a sputtering method using a sputtering apparatus to which a plurality of targets can be attached. In particular, the Si/Mo periodically laminated structure may be formed with using a silicon (Si) target for forming a silicon (Si)-containing layer such as a Si layer and a SiN layer, and a molybdenum (Mo) target for forming a molybdenum (Mo)-containing layer such as a Mo layer, and using a rare gas such as helium (He) gas, argon (Ar) gas, krypton (Kr) gas and xenon (Xe) gas in the case of forming the Si layer or the Mo layer, and further using nitrogen (N₂) gas as a reactive gas with the rare gas in the case of forming the SiN layer Each layer of the Si/Mo periodically laminated structure may be sequentially formed by sputtering the Si target and Mo target by turns.

The protection film is a film for protecting the reflective multilayer film. The protection film is provided to protect the reflective multilayer film, for example, in cleaning in processing to a reflective mask, or in correction of the reflective mask. A stress of the absorber film formed on the protection film depends on the film composition, film formation conditions, and others. However, for example, when a degree of nitridation is high in an absorber film containing tantalum (Ta) and nitrogen (N), there is a limit to reduce stress in the absorber film by simply changing the film composition or film formation conditions. Further, when the film composition or film formation conditions are changed to reduce stress in the absorber film, other properties required for the absorber film, such as reflectance, film qualities, etching rate, and sheet resistance change. Since there is usually a trade-off relationship between film stress and the other properties, there is a limit to reduce stress in the absorber film with maintaining the properties necessary for the absorber film.

The protection film of the invention has effect of relaxing stress of the absorber film, thus, when an absorber film is formed in contact with the protection film of the invention, a reflective mask blank including an absorber film having a low film stress with ensuring properties necessary for the absorber film can be provided. Further, the protection film of the invention can provide an absorber film having a film stress of not more than a film stress in the case of forming the absorber film directly on the substrate.

It can be said that the film stress in the case of forming the absorber film directly on the substrate (i.e., a ΔTIR representing a difference between a TIR of the substrate before forming the absorber film and a TIR of the substrate after forming the absorber film) is a film stress of the absorber film not affected by other films. With respect to a film stress of the absorber film in the case of forming sequentially a reflective multilayer film, a protection film and an absorber film (i.e., a ΔTIR representing a difference between a TIR of the substrate on which the reflective multilayer film and the protection film are formed before forming the absorber film and a TIR of the substrate after forming the absorber film), the protection film of the invention can provide the film stress of not more than a film stress of the absorber film not affected by other films.

In the invention, the protection film is composed of a material consisting of ruthenium (Ru), niobium (Nb) and oxygen (O). Further, the protection film is configured such that a composition at the side close to the reflective multilayer film, in particular, a composition at the interface or the interface portion close to the reflective multilayer film is different from a composition at the side in contact with the absorber film, in particular, a composition at the interface or the interface portion in contact with the absorber film.

The composition of the protection film at the side close to the reflective multilayer film is a composition containing ruthenium (Ru) and being free of oxygen (O). The composition of the protection film at the side close to the reflective multilayer film may contain niobium (Nb). When the composition at the side close to the reflective multilayer film is configured such a composition, decrease in reflectance due to the formed protection film can be suppressed, and a sufficient reflectance with respect to exposure light in the reflective mask obtained from the reflective mask blank can be ensured. The composition of the protection film at the side close to the reflective multilayer film preferably consists of ruthenium (Ru), or ruthenium (Ru) and niobium (Nb).

When the composition of the protection film at the side close to the reflective multilayer film consists of ruthenium (Ru) and niobium (Nb), the composition has a niobium (Nb) content of preferable not more than 60 at%, more preferably not more than 50 at%, even more preferably not more than 40 at%, and more than 0 at%, preferably not less than 5 at%, more preferably not less than 10 at%, even more preferably not less than 20 at%. If the niobium (Nb) content is too high, resistance to chlorine-based etching in etching of the absorber film is deteriorated, and if the protection film is damaged, reflectance of the reflective multilayer film may decrease, and resistance to SPM cleaning may be is deteriorated.

On the other hand, the composition of the protection film at the side in contact with the absorber film is a composition containing ruthenium (Ru), niobium (Nb) and oxygen (O), or niobium (Nb) and oxygen (O). When the composition of the protection film at the side in contact with the absorber film is configured such a composition, it can relax film stress of the absorber film formed in contact with the protection film. Further, resistance to chlorine-based etching in etching of the absorber film can be improved.

The composition of the protection film at the side in contact with the absorber film preferably has a high content of the sum of niobium (Nb) and oxygen (O). The content of the sum of niobium (Nb) and oxygen (O) is preferably not less than 60 at%, more preferably not less than 70 at%, even more preferably not less than 80 at%.

The protection film has a thickness of preferably not less than 2 nm, more preferably not less than 3 nm, and preferably not more than 5 nm, more preferably not more than 4 nm.

The composition of the protection film may have a niobium (Nb) content that stepwise and/or continuously increases or decreases along the thickness direction from the side close to the reflective multilayer film to the side in contact with the absorber film. The composition of the protection film may have an oxygen (O) content that stepwise and/or continuously increases or decreases along the thickness direction from the side close to the reflective multilayer film to the side in contact with the absorber film.

When the composition of the protection film at the side close to the reflective multilayer film that contains ruthenium (Ru) and is free of oxygen (O), preferably contains ruthenium (Ru) and niobium (Nb) and is free of oxygen (O), more preferably consists of ruthenium (Ru) or ruthenium (Ru) and niobium (Nb), and the composition of the protection film at the side in contact with the absorber film that consists of ruthenium (Ru), niobium (Nb) and oxygen (O), or niobium (Nb) and oxygen (O) are configured, the protection film can relax film stress of the absorber film formed in contact with the protection film with suppressing decrease of reflectance due to the formed protection film, and resistance to chlorine-based etching in etching of the absorber film can be ensured.

Examples of forming methods of the protection film that has the composition at the side close to the reflective multilayer film containing ruthenium (Ru) and being free of oxygen (O), and the composition at the side in contact with the absorber film consisting of ruthenium (Ru), niobium (Nb) and oxygen (O), or niobium (Nb) and oxygen (O) include a method by sputtering with using, as a target, a ruthenium (Ru) target, and an optional niobium (Nb) target, and with using, as a sputtering gas, a rare gas such as helium (He) gas, argon (Ar) gas, krypton (Kr) gas and xenon (Xe) gas. In the sputtering, first, the side close to the reflective multilayer film of the protection film may be formed, and then the side in contact with the absorber film may be formed by reactive sputtering with using, as a reactive gas, oxygen (O₂) gas with the rare gas. In the sputtering, a ratio of ruthenium (Ru) to niobium (Nb) can be varied by changing a ratio of powers applied to the ruthenium (Ru) target and the niobium (Nb) target. Further, the oxygen (O) content can be varied by changing an amount of oxygen (O₂) gas introduced.

Further, to form a composition containing oxygen (O), examples of forming methods of the protection film include, a method in which the protection film not containing oxygen (O) is formed by sputtering with using, as a target, a ruthenium (Ru) target, and an optional niobium (Nb) target, and with using, as a sputtering gas, a rare gas such as helium (He) gas, argon (Ar) gas, krypton (Kr) gas and xenon (Xe) gas, and then the composition containing oxygen (O) at the side in contact with the absorber film is formed by performing ashing treatment using oxygen plasma, or heat treatment in the presence of oxygen gas such as in the atmosphere.

Particularly, the method in which the composition at the side in contact with the absorber film is formed to the composition containing oxygen (O) by heat treatment is preferable, because it is easy and has a low risk of generating defects. The high heat treatment temperature is easily to oxidize. However, the temperature is preferably not more than 150 °C in consideration of decrease in reflectance. Furthermore, when the heat treatment temperature is not more than 150 °C, in order to enhance progress of oxidation in the case of heat treatment for the film not containing oxygen (O), the composition at the side in contact with the absorber film preferably has a high niobium (Nb) content, or is preferably free of ruthenium (Ru). Further, when the composition of the protection film at the side in contact with the absorber film is changed to the composition containing oxygen (O) by heat treatment, it is preferable that a rate of change of a reflectance to exposure light (EUV light) before and after the heat treatment is not more than 0.5% in the state in which the reflective multilayer film and the protection film are stacked.

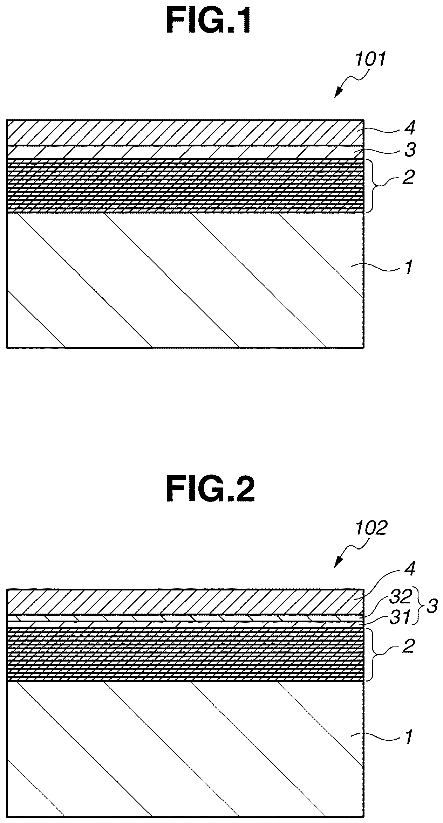

The protection film may consist of a single layer, and in this case, the protection film is a compositionally graded layer in which the composition is varied along the thickness direction. FIG. 1 is a cross-sectional view illustrating an example of first embodiment of a reflective mask blank of the invention. This reflective mask blank 101 includes a substrate1, and on the substrate 1, a reflective multilayer film 2 that is formed in contact with the substrate 1, a protection film 3 that is formed in contact with the reflective multilayer film 2, and an absorber film 4 that is formed in contact with the protection film 3. In this case, the protection film consists of a single layer, and may have a compositional gradation in which the composition is stepwise and/or continuously varied along the thickness direction.

The protection film preferably consists of two or three or more layers. FIG. 2 is a cross-sectional view illustrating an example of second embodiment of a reflective mask blank of the invention. This reflective mask blank 102 includes a substrate 1, and on the substrate 1, a reflective multilayer film 2 that is formed in contact with the substrate 1, a protection film 3 that is formed in contact with the reflective multilayer film 2, and an absorber film 4 that is formed in contact with the protection film 3. In this case, the protection film consists of a layer (A) 31 that is formed in contact with the reflective multilayer film 2, and a layer (B) 32 that is formed in contact with the absorber film 4. In addition, the protection film may consist of four or more layers.

When the protection film consists of two layers, the protection film may be configured by the layer (layer (A)) close to the reflective multilayer film that is a layer containing ruthenium (Ru) and being free of oxygen (O), and the layer (layer (B)) in contact with the absorber film that is a layer consisting of ruthenium (Ru), niobium (Nb) and oxygen (O), or niobium (Nb) and oxygen (O).

The layer (A) is a layer containing ruthenium (Ru) and being free of oxygen (O). The layer (A) may contain niobium (Nb). When the layer (A) is configured such a layer, decrease in reflectance due to the formed protection film can be suppressed, and a sufficient reflectance with respect to exposure light in the reflective mask obtained from the reflective mask blank can be ensured. The layer (A) is preferably a layer consists of ruthenium (Ru), or ruthenium (Ru) and niobium (Nb).

When the composition of the film (A) consists of ruthenium (Ru) and niobium (Nb), at the side close to the reflective multilayer film, the layer (A) has a niobium (Nb) content of preferable not more than 60 at%, more preferably not more than 50 at%, even more preferably not more than 40 at%, and more than 0 at%, preferably not less than 5 at%, more preferably not less than 10 at%, even more preferably not less than 20 at%. If the niobium (Nb) content is too high, resistance to chlorine-based etching in etching of the absorber film is deteriorated, and if the protection film is damaged, reflectance of the reflective multilayer film may decrease, and resistance to SPM cleaning may be is deteriorated.

On the other hand, the layer (B) is a layer containing ruthenium (Ru), niobium (Nb) and oxygen (O), or niobium (Nb) and oxygen (O). When the layer (B) is configured such a layer, the layer (B) can be a layer that can relax film stress of the absorber film formed in contact with the protection film (a stress relaxing layer). Further, the layer can be a layer having high resistance to chlorine-based etching in etching of the absorber film.

The composition of the film (B) preferably has a high content of the sum of niobium (Nb) and oxygen (O). At the side in contact with the absorber film, the film (B) has a content of the sum of niobium (Nb) and oxygen (O) of preferably not less than 60 at%, more preferably not less than 70 at%, even more preferably not less than 80 at%.

The protection film has a thickness (in the case that the protection film is a multilayer, a thickness of the total of all layers constituting the multilayer) of preferably not less than 2 nm, more preferably not less than 3 nm, and preferably not more than 5 nm, more preferably not more than 4 nm. In the case that the protection film consists of the layer (A) and the layer (B), the layer (B) has a thickness of preferably not less than 10%, more preferably not less than 15%, and preferably not more than 50%, more preferably not more than 30%, of the thickness of the protection film. If the thickness of the film (B) is too thick, decrease in reflectance due to the formed protection film may be enlarged, and resistance to SPM cleaning may be is deteriorated. In particular, the layer (B) has a thickness of preferably not less than 0.5 nm, more preferably not less than 0.6 nm, and preferably not more than 2 nm, more preferably not more than 1.5 nm.

Each of both of the compositions of the film (A) and the film (B) may have a niobium (Nb) content that stepwise and/or continuously increases or decreases along the thickness direction from the reflective multilayer film side to the absorber film side. The layer (A) may have a niobium (Nb) content that stepwise and/or continuously increases or decreases along the thickness direction from the side close to the reflective multilayer film to the side in contact with the layer (B). The layer (B) may have a niobium (Nb) content that stepwise and/or continuously increases or decreases along the thickness direction from the side in contact with the layer (A) to the side in contact with the absorber film. In this case, each of the layer (A) and the layer (B) may be configured by two or more sublayers that have different composition each other, or by a compositionally graded layer.

The compositions of the (B) may have an oxygen (O) content that stepwise and/or continuously increases along the thickness direction from the reflective multilayer film side to the absorber film side. The layer (B) may have an oxygen (O) content that stepwise and/or continuously increases along the thickness direction from the side in contact with the layer (A) to the side in contact with the absorber film. In this case, the layer (B) may be configured by two or more sublayers that have different composition each other, or by a compositionally graded layer.

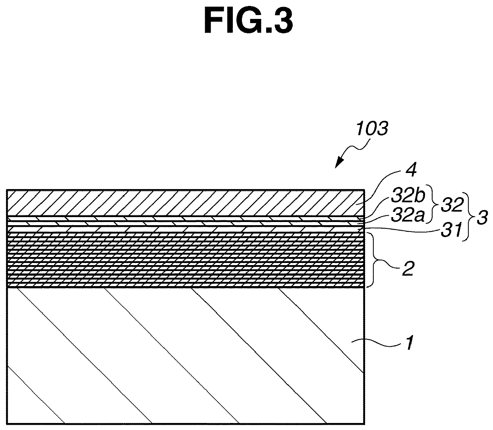

FIG. 3 is a cross-sectional view illustrating an example of third embodiment of a reflective mask blank of the invention. This reflective mask blank 103 includes a substrate 1, and on the substrate1, a reflective multilayer film 2 that is formed in contact with the substrate 1, a protection film 3 that is formed in contact with the reflective multilayer film 2, and an absorber film 4 that is formed in contact with the protection film 3. The protection film 3 consists of a layer (A) 31 that is formed in contact with the reflective multilayer film 2, and a layer (B) 32 that is formed in contact with the absorber film 4, and the layer (B) 32 consists of a first sublayer 32a that is formed in contact with the layer (A) 31, and a second sublayer 32b that is formed in contact with the absorber film 4. In this case, the protection film has a three-layer structure consists of the layer (A) 31, the first sublayer 32a, and the second sublayer 32b.

Examples of forming methods of the protection film that includes the layer (A) containing ruthenium (Ru) and being free of oxygen (O), and the layer (B) consisting of ruthenium (Ru), niobium (Nb) and oxygen (O), or niobium (Nb) and oxygen (O) include a method by sputtering with using, as a target, a ruthenium (Ru) target, and an optional niobium (Nb) target, and with using, as a sputtering gas, a rare gas such as helium (He) gas, argon (Ar) gas, krypton (Kr) gas and xenon (Xe) gas. In the sputtering, first, the layer (A) may be formed, and then the layer (B) may be formed by reactive sputtering with using, as a reactive gas, oxygen (O₂) gas with the rare gas. In the sputtering, a ratio of ruthenium (Ru) to niobium (Nb) can be varied by changing a ratio of powers applied to the ruthenium (Ru) target and the niobium (Nb) target. Further, the oxygen (O) content can be varied by changing an amount of oxygen (O₂) gas introduced.

Further, to form a composition containing oxygen (O), examples of forming methods of the protection film including the film (A) and the film (B) include, a method in which the protection film not containing oxygen (O) is formed by sputtering with using, as a target, a ruthenium (Ru) target, and an optional niobium (Nb) target, and with using, as a sputtering gas, a rare gas such as helium (He) gas, argon (Ar) gas, krypton (Kr) gas and xenon (Xe) gas, and then the composition containing oxygen (O) at the side in contact with the absorber film is formed by performing ashing treatment using oxygen plasma, or heat treatment in the presence of oxygen gas such as in the atmosphere.

Particularly, the method in which the composition at the side in contact with the absorber film is formed to the composition containing oxygen (O) by heat treatment is preferable because it is easy and has a low risk of generating defects. The high heat treatment temperature is easily to oxidize. However, the temperature is preferably not more than 150 °C in consideration of decrease in reflectance. Furthermore, when the heat treatment temperature is not more than 150 °C, in order to enhance progress of oxidation in the case of heat treatment for the film not containing oxygen (O), the composition at the side in contact with the absorber film preferably has a high niobium (Nb) content, or is preferably free of ruthenium (Ru). Further, when the film (B) is formed such that the composition of the protection film at the side in contact with the absorber film is changed to the composition containing oxygen (O) by heat treatment, it is preferable that a rate of change of a reflectance to exposure light (EUV light) before and after the heat treatment is not more than 0.5% in the state in which the reflective multilayer film and the protection film are stacked.

The absorber film may be composed of a material that absorbs exposure light and can be processed to a pattern, for example, a material contains tantalum (Ta), however not particularly limited thereto. The absorber film preferably contains tantalum (Ta) and nitrogen (N) in the viewpoint of processed shape and resistance. Further, when the absorber film has a microcrystalline structure or an amorphous structure, it is better for reducing film stress of the absorber film than an absorber film having a highly crystalline structure (a structure with many metal bonds such that a high intensity peak is detected in XRD). The contained nitrogen (N) is effective in forming the absorber film having a microcrystalline structure or an amorphous structure. Therefore, the absorber film preferably has a nitrogen (N) content of not less than 35 at%. The absorber film preferably has an upper limit of the nitrogen (N) content of not more than 45 at%, however, not particularly limited thereto. The absorber film preferably has an atomic ratio (Ta/N) of tantalum (Ta) to nitrogen (N) of 55/45 to 65/35.

The absorber film may consist of tantalum (Ta) and nitrogen (N), and may further contain at least one additive element selected from the group consisting of hydrogen (H), boron (B), carbon (C), silicon (Si), molybdenum (Mo), zirconium (Zr), chromium (Cr) germanium (Ge) and aluminum (Al). The contained additive element is effective in forming the absorber film having a microcrystalline structure or an amorphous structure. In this case, the absorber film preferably has a content of the additive element(s) of not more than 20 at%.

It is preferable that the absorber film has a lower film stress. In the invention, a reflective mask blank having a ΔTIR calculated from TIR values measured before and after forming the absorber film (a difference between a TIR of the substrate before forming the absorber film and a TIR of the substrate after forming the absorber film) of preferably not more than 0.5 µm, more preferably not more than 0.3 µm in absolute value can be provided.

The absorber film preferably consists of a single layer. However, the surface portion of the absorber film is usually naturally-oxidized. In that case, the absorber film contains oxygen (O). The absorber film contains oxygen (O) preferably only at the surface layer (surface oxidized layer) of the absorber film at the remotest from the substrate. In this case, the absorber film consists of a substrate-side layer and a surface layer, and the surface layer containing oxygen (O) preferably has a thickness of not more than 2 nm. Further, the surface layer containing oxygen (O) preferably has an oxygen content of not less than 20 at% and not more than 40 at% at the side remotest from the substrate. If the surface layer is too thick or the oxygen (O) content of the surface layer is too high, the absorber film may be hard to absorb the exposure light.

The absorber film has a thickness of preferably nor less than 50 nm, more preferably not less than 55 nm, and preferably not more than 80 nm, more preferably not more than 70 nm. The absorber film has a sheet resistance of preferably not more than 1×10⁶ Ω /square, more preferably not more than 1×10⁵ Ω /square. Further, the absorber film has a surface roughness Sq of preferably not more than 0.8 nm, more preferably not more than 0.6 nm.

The absorber film can be formed by sputtering, and the sputtering is preferably magnetron sputtering. In particular, as a target, a metal target such as a tantalum (Ta) target, and a metal target of the additive element in the case that the additive element is metal, a metal compound target such as a tantalum (Ta) nitrogen target, and a target containing tantalum (Ta) and the additive element in the case that the additive element is nonmetal can be used. Further, as a sputtering gas, a rare gas such as helium (He) gas, argon (Ar) gas, krypton (Kr) gas, or xenon (Xe) gas can be used. The absorber film can be formed by reactive sputtering using a reactive gas such as an oxygen-containing gas, a nitrogen-containing gas and a carbon-containing gas along with the rare gas. Examples of the reactive gases include oxygen (O₂) gas, nitrogen (N₂) gas, nitrogen oxide gases such as nitrous oxide (N₂O) gas, nitric oxide (NO) gas and nitrogen dioxide (NO₂) gas, and carbon oxide gases such as carbon monoxide (CO) gas and carbon dioxide (CO₂) gas.

A hard mask film (an etching mask film for the absorber film) having different etching properties from the absorber film may be formed on the absorber film (at the side remote from the substrate), preferably in contact with the absorber film. The hard mask film is a film that acts as an etching mask when the absorber film is dry-etched. After a pattern of the absorber film is formed, the hard mask film may be left, for example, as a reflectance reducing film for reducing reflectance at a wavelength of light used in inspection such as pattern inspection, or may be removed to be absent on the reflective mask. Examples of the materials of the hard mask film include a material containing chromium (Cr). Particularly, a hard mask film composed of a material containing chromium (Cr) is preferable in the case that the absorber film is composed of a material containing tantalum (Ta) and free of chromium (Cr). When a layer that mainly assumes a function for reducing reflectance at a wavelength of light used in inspection such as pattern inspection (a reflectance reducing layer) is formed as a part of the absorber film, the hard mask film may be formed on the reflectance reducing layer of the absorber film. The hard mask film may be formed by, for example, a magnetron sputtering method. The hard mask has a thickness of normally about 5 to 20 nm, however, not particularly limited thereto.

A back-surface conductive film used for electrostatic chucking to attach a reflective mask to an exposure apparatus may be formed on the other main surface (back surface or lower side) which is opposite across the substrate to the one main surface, preferably in contact with the other main surface.

The back-surface conductive film preferably has a sheet resistance of not more than 100 Q/square, and a material for the back-surface conductive film is not limited. Examples of the materials of the back-surface conductive film include, for example, a material containing tantalum (Ta) or chromium (Cr). The material containing tantalum (Ta) or chromium (Cr) may contain oxygen (O), nitrogen (N), carbon (C), boron (B), or other elements. Examples of the materials containing tantalum (Ta) include, for example, Ta simple substance, and a tantalum (Ta) compound such as TaO, TaN, TaON, TaC, TaCN, TaCO, TaCON, TaB, TaOB, TaNB, TaONB, TaCB, TaCNB, TaCOB and TaCONB. Examples of the materials containing chromium (Cr) include, for example, Cr simple substance, and a chromium (Cr) compound such as CrO, CrN, CrON, CrC, CrCN, CrCO, CrCON, CrB, CrOB, CrNB, CrONB, CrCB, CrCNB, CrCOB and CrCONB.

The back-surface conductive film has a thickness of normally about 5 to 100 nm, however, not limited particularly thereto as long as the thickness is enough to act for use in electrostatic chucking. The back-surface conductive film is preferably formed so as to have a thickness at which film stresses between the back-surface conductive film, and the reflective multilayer film, the protection film and a pattern of the absorber film are balanced after obtaining the reflective mask, in other words, after forming the pattern of the absorber film. The back-surface conductive film may be formed before forming the reflective multilayer film, or after forming all the films on the substrate at the reflective multilayer film side. After forming a part of the films on the substrate at the reflective multilayer film side, the back-surface conductive film may be formed, and then the remainder of the films at the reflective multilayer film side may be formed on the substrate. The back-surface conductive film can be formed by, for example, a magnetron sputtering method.

The reflective mask blank of the invention may include a resist film formed on the side remotest from the substrate. The resist film is preferably an electron beam (EB) resist.

A reflective mask that includes for example, the substrate, the reflective multilayer film formed on one main surface of the substrate, the protection film formed in contact with the reflective multilayer film, and a pattern (circuit pattern or mask pattern) of the absorbing film formed in contact with the protection film can be obtained from the reflective mask blank. In a reflective mask, a transfer pattern is formed by a difference in reflectance between a portion where an absorber film is formed and a portion where an absorber film is not formed.

In particular, first, a resist film is formed on a reflective mask blank, or a reflective mask blank on which a resist film is formed is prepared, pattern drawing and resist patterning are performed by electron beam lithography. Next, the absorber film is removed with using the resist pattern as an etching mask. Alternatively, a pattern of a hard mask film is formed with using the resist pattern as an etching mask, and the absorber film is removed with using the pattern of the hard mask film as an etching mask. Accordingly, the remaining portion of the absorbent film is formed as a pattern of the absorbent film. Thereafter, a reflective mask can be obtained by removing the resist pattern and, if necessary, removing the pattern of the hard mask film.

### EXAMPLES

Examples of the invention are given below by way of illustration and not by way of limitation.

### Reference Example 1

A TaN film having a thickness of 59 nm was formed on a main surface of a low thermal expansion glass substrate (SiO₂-TiO₂-based glass substrate) having dimensions of 152 mm-square and 6.35 mm-thick. The TaN film was formed by DC pulse magnetron sputtering while rotating the substrate. The TaN film was formed by placing the low thermal expansion glass substrate in a chamber, feeding Ar gas (40 vol%) and N₂ gas (60 vol%), setting a chamber pressure of 0.48 Pa, and applying a power of 1,800W to the tantalum (Ta) target.

After the obtained TaN film was taken out into the atmosphere at room temperature, its composition was measured with using an X-ray photoelectron spectroscopy (XPS) device (K-Alpha, manufactured by Thermo Fisher SCIENTIFIC). Tantalum (Ta) and nitrogen (N) were 57 at% and 43 at%, respectively, based on the total of tantalum (Ta) and nitrogen (N). In this case, a surface oxidation layer was formed due to natural oxidation in the atmosphere (thickness: 1 nm). The oxygen content of the surface oxidized layer was 25 at% based on the total of tantalum (Ta), nitrogen (N) and oxygen (O) at the side remotest the substrate of the surface oxidized layer. The film was obtained as a film corresponding to an absorber film.

The obtained film was subjected to X-ray diffraction (XRD) measurement using an X-ray diffractometer (SmartLab, manufactured by Rigaku Co., Ltd.) to confirm the crystal phases contained in the film. None of β-TaN crystal phase, α-Ta crystal phase, and TaN crystal phase which is cubic phase was detected. Further, before and after forming the absorber film, warpages (TIR) within a 142 mm-square at the center of the substrate surface was measured with using a flatness tester (Tropel Ultra Flat 200Mask, manufactured by CORNING; the same in the following measurements of TIR). An amount of change in warpage (ΔTIR) between the warpages (TIR) before and after forming the absorber film was calculated, and ΔTIR was 0.39 µm in absolute value.

### Example 1

A reflective multilayer film having a thickness of 284 nm was formed on a main surface of a low thermal expansion substrate (SiO₂-TiO₂-based glass substrate) having dimensions of 152 mm-square and 6.35 mm-thick while rotating the substrate by DC pulse magnetron sputtering with using a molybdenum (Mo) target and a silicon (Si) target that were placed so as to face to the main surface of the substrate. Each of the targets was attached to a sputtering apparatus that is capable of attaching two targets and discharging the targets one by one, or both targets at the same time, and the substrate was placed into the sputtering apparatus.

First, a silicon (Si) layer having a thickness of 4 nm was formed by applying an electric power to the silicon (Si) target while feeding argon (Ar) gas into a chamber, then, the application of electric power to the silicon (Si) target was terminated. Next, a molybdenum (Mo) layer having a thickness of 3 nm was formed by applying an electric power to the molybdenum (Mo) target while feeding argon (Ar) gas into the chamber, then, the application of electric power to the molybdenum (Mo) target was terminated. The one cycle which is a set of the formations of the silicon (Si) layer and the molybdenum (Mo) layer was repeated for 40 cycles, and after forming the molybdenum (Mo) layer at 40th cycle, finally, a silicon (Si) layer having a thickness of 4 nm was formed by the above-described method. Accordingly, the reflective multilayer film was formed.

Next, a film composed of RuNb was formed on the reflective multilayer film while rotating the substrate by DC pulse magnetron sputtering with using a ruthenium (Ru) target and a niobium (Nb) target that were placed so as to face to the main surface of the substrate. Each of the targets was attached to another sputtering apparatus that is capable of attaching two targets and discharging the targets one by one, or both targets at the same time. After forming the reflective multilayer film, the substrate having the formed reflective multilayer film was transported without taking it out to the atmosphere, from the sputtering apparatus in which the reflective multilayer film was formed, through a transport path which was maintained in vacuum condition, and was placed into the other sputtering apparatus.

First, a film composed of RuNb and having a compositional gradation in which niobium (Nb) increases along the thickness direction was formed with, at first, applying electric powers to the ruthenium (Ru) target and the niobium (Nb) target at the same time while feeding argon gas into a chamber, and then gradually increasing the electric power applied to the niobium (Nb) target over time.

Next, the substrate on which the reflective multilayer film and the film composed of RuNb were formed was subjected to heat treatment in the air with using a hot plate type heating device at 150 °C for 15 minutes to oxidize the surface portion of the film composed of RuNb. The thickness of the formed oxide layer was 1.5 nm, and the total content of niobium (Nb) and oxygen (O) based on the total of ruthenium (Ru), niobium (Nb) and oxygen (O) was 70 at% at the side on which an absorber film will be formed.

The film after heat treatment was obtained as a protection film consisting of a layer (A) composed of RuNb, having a compositional gradation in which the niobium (Nb) content based on the total of ruthenium (Ru) and niobium (Nb) increases from 10 at% to 20 at% along the thickness direction, and having a thickness of 2.4 nm, and a layer (B) composed of RuNbO and having a thickness of 1.5 nm. The total thickness of the protection film was 3.9 nm.

Next, an absorbent film was formed on the protection film in the same manner as in Reference Example 1. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.27 µm in absolute value.

### Example 2

A reflective multilayer film was formed on a main surface of a low thermal expansion substrate (SiO₂-TiO₂-based glass substrate) having dimensions of 152 mm-square and 6.35 mm-thick in the same manner as in Example 1.

Next, a film composed of RuNb was formed on the reflective multilayer film while rotating the substrate by DC pulse magnetron sputtering with using a ruthenium (Ru) target and a niobium (Nb) target that were placed so as to face to the main surface of the substrate. Each of the targets was attached to another sputtering apparatus that is capable of attaching two targets and discharging the targets one by one, or both targets at the same time. After forming the reflective multilayer film, the substrate having the formed reflective multilayer film was transported without taking it out to the atmosphere, from the sputtering apparatus in which the reflective multilayer film was formed, through a transport path which was maintained in vacuum condition, and was placed into the other sputtering apparatus.

A film composed of RuNb and having a compositional gradation in which niobium (Nb) increases along the thickness direction was formed, at first, by applying electric powers to the ruthenium (Ru) target and the niobium (Nb) target at the same time while feeding argon gas into a chamber, and then by gradually increasing the electric power applied to the niobium (Nb) target over time.

Next, the substrate on which the reflective multilayer film and the film composed of RuNb were formed was subjected to heat treatment in the air with using a hot plate type heating device at 150 °C for 15 minutes to oxidize the surface portion of the film composed of RuNb. The thickness of the formed oxide layer was 1.5 nm, and the total content of niobium (Nb) and oxygen (O) based on the total of ruthenium (Ru), niobium (Nb) and oxygen (O) was 88 at% at the side on which an absorber film will be formed.

The film after heat treatment was obtained as a protection film consisting of a layer (A) composed of RuNb, having a compositional gradation in which the niobium (Nb) content based on the total of ruthenium (Ru) and niobium (Nb) increases from 15 at% to 25 at% along the thickness direction, and having a thickness of 2.4 nm, and a layer (B) composed of RuNbO and having a thickness of 1.5 nm. The total thickness of the protection film was 3.9 nm.

Next, an absorbent film was formed on the protection film in the same manner as in Reference Example 1. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.23 µm in absolute value.

### Example 3

A reflective multilayer film was formed on a main surface of a low thermal expansion substrate (SiO₂-TiO₂-based glass substrate) having dimensions of 152 mm-square and 6.35 mm-thick in the same manner as in Example 1.

Next, a film consisting of a layer composed of RuNb and a layer composed of Nb was formed on the reflective multilayer film while rotating the substrate by DC pulse magnetron sputtering with using a ruthenium (Ru) target and a niobium (Nb) target that were placed so as to face to the main surface of the substrate. Each of the targets was attached to another sputtering apparatus that is capable of attaching two targets and discharging the targets one by one, or both targets at the same time. After forming the reflective multilayer film, the substrate having the formed reflective multilayer film was transported without taking it out to the atmosphere, from the sputtering apparatus in which the reflective multilayer film was formed, through a transport path which was maintained in vacuum condition, and was placed into the other sputtering apparatus.

A layer composed of RuNb and having a compositional gradation in which niobium (Nb) increases along the thickness direction was formed, at first, by applying electric powers to the ruthenium (Ru) target and the niobium (Nb) target at the same time while feeding argon gas into a chamber, and then gradually increasing the electric power applied to the niobium (Nb) target over time. Further, a layer composed of Nb was formed by applying an electric power to the niobium (Nb) target only. Accordingly, the film consisting of the layer composed of RuNb and the layer composed of Nb was formed.

Next, the substrate on which the reflective multilayer film, and the film consisting of the layer composed of RuNb and the layer composed of Nb were formed was subjected to heat treatment in the air with using a hot plate type heating device at 150 °C for 15 minutes to oxidize the surface portion of the film consisting of the layer composed of RuNb and the layer composed of Nb. The thickness of the formed oxide layer was 1.5 nm, and the total content of niobium (Nb) and oxygen (O) based on the total of ruthenium (Ru), niobium (Nb) and oxygen (O) was 100 at% at the side on which an absorber film will be formed.

The film after heat treatment was obtained as a protection film consisting of a layer (A) composed of RuNb, having a compositional gradation in which the niobium (Nb) content based on the total of ruthenium (Ru) and niobium (Nb) increases from 10 at% to 20 at% along the thickness direction, and having a thickness of 2.4 nm, and a layer (B) consisting of a first sublayer composed of RuNbO and having a thickness of 1 nm at the reflective multilayer film side, and a second layer composed of NbO and having a thickness of 0.5 nm at the side on which an absorber film will be formed. The total thickness of the protection film was 3.9 nm.

Next, an absorbent film was formed on the protection film in the same manner as in Reference Example 1. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.23 µm in absolute value.

### Comparative Example 1

A reflective multilayer film was formed on a main surface of a low thermal expansion substrate (SiO₂-TiO₂-based glass substrate) having dimensions of 152 mm-square and 6.35 mm-thick in the same manner as in Example 1.

Next, a film composed of Ru was formed on the reflective multilayer film while rotating the substrate by DC pulse magnetron sputtering with using a ruthenium (Ru) target that was placed so as to face to the main surface of the substrate. The target was attached to another sputtering apparatus that is capable of attaching two targets and discharging the targets one by one, or both targets at the same time. After forming the reflective multilayer film, the substrate having the formed reflective multilayer film was transported without taking it out to the atmosphere, from the sputtering apparatus in which the reflective multilayer film was formed, through a transport path which was maintained in vacuum condition, and was placed into the other sputtering apparatus.

A film composed of Ru was formed by applying electric powers to the ruthenium (Ru) target while feeding argon gas into a chamber. The film was obtained as a protection film. In this example, heat treatment was not subjected. The total thickness of the protection film was 3.9 nm.

Next, an absorbent film was formed on the protection film in the same manner as in Reference Example 1. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.53 µm in absolute value.

### Example 4

A reflective multilayer film was formed on a main surface of a low thermal expansion substrate (SiO₂-TiO₂-based glass substrate) having dimensions of 152 mm-square and 6.35 mm-thick in the same manner as in Example 1.

Next, a film composed of RuNb was formed on the reflective multilayer film while rotating the substrate by DC pulse magnetron sputtering with using a ruthenium (Ru) target and a niobium (Nb) target that were placed so as to face to the main surface of the substrate. Each of the targets was attached to another sputtering apparatus that is capable of attaching two targets and discharging the targets one by one, or both targets at the same time. After forming the reflective multilayer film, the substrate having the formed reflective multilayer film was transported without taking it out to the atmosphere, from the sputtering apparatus in which the reflective multilayer film was formed, through a transport path which was maintained in vacuum condition, and was placed into the other sputtering apparatus.

A film composed of RuNb and having a compositional gradation in which niobium (Nb) increases along the thickness direction was formed, at first with applying electric powers to the ruthenium (Ru) target and the niobium (Nb) target at the same time while feeding argon gas into a chamber, and then gradually increasing the electric power applied to the niobium (Nb) target over time.

Next, the substrate on which the reflective multilayer film and the film composed of RuNb were formed was subjected to heat treatment in the air with using a hot plate type heating device at 150 °C for 15 minutes to oxidize the surface portion of the film composed of RuNb. The thickness of the formed oxide layer was 1.5 nm, and the total content of niobium (Nb) and oxygen (O) based on the total of ruthenium (Ru), niobium (Nb) and oxygen (O) was 60 at% at the side on which an absorber film will be formed.

The film after heat treatment was obtained as a protection film consisting of a layer (A) composed of RuNb, having a compositional gradation in which the niobium (Nb) content based on the total of ruthenium (Ru) and niobium (Nb) increases from 5 at% to 10 at% along the thickness direction, and having a thickness of 2.4 nm, and a layer (B) composed of RuNbO and having a thickness of 1.5 nm. The total thickness of the protection film was 3.9 nm.

Next, an absorbent film was formed on the protection film in the same manner as in Reference Example 1. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.39 µm in absolute value.

### Comparative Example 2

A reflective multilayer film was formed on a main surface of a low thermal expansion substrate (SiO₂-TiO₂-based glass substrate) having dimensions of 152 mm-square and 6.35 mm-thick in the same manner as in Example 1.

Next, a film composed of RuNb was formed on the reflective multilayer film while rotating the substrate by DC pulse magnetron sputtering with using a ruthenium (Ru) target and a niobium (Nb) target that were placed so as to face to the main surface of the substrate. Each of the targets was attached to another sputtering apparatus that is capable of attaching two targets and discharging the targets one by one, or both targets at the same time. After forming the reflective multilayer film, the substrate having the formed reflective multilayer film was transported without taking it out to the atmosphere, from the sputtering apparatus in which the reflective multilayer film was formed, through a transport path which was maintained in vacuum condition, and was placed into the other sputtering apparatus.

A film composed of RuNb and having a compositional gradation in which niobium (Nb) increases along the thickness direction was formed, at first, with applying electric powers to the ruthenium (Ru) target and the niobium (Nb) target at the same time while feeding argon gas into a chamber, and then gradually increasing the electric power applied to the niobium (Nb) target over time. The film was obtained as a protection film. In this example, heat treatment was not subjected. The total thickness of the protection film was 3.9 nm.

Next, an absorbent film was formed on the protection film in the same manner as in Reference Example 1. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.53 µm in absolute value.

### Reference Example 2

A TaSiN film having a thickness of 59 nm was formed on a main surface of a low thermal expansion glass substrate (SiO₂-TiO₂-based glass substrate) having dimensions of 152 mm-square and 6.35 mm-thick. The TaSiN film was formed by DC pulse magnetron sputtering while rotating the substrate. The TaSiN film was formed by placing the low thermal expansion glass substrate in a chamber, feeding Ar gas (67 vol%) and N₂ gas (33 vol%), setting a chamber pressure of 0.27 Pa, and applying a power of 1,620W to the tantalum (Ta) target, and a power of 180W to the silicon (Si) target.

After the obtained TaSiN film was taken out into the atmosphere at room temperature, its composition was measured with using an X-ray photoelectron spectroscopy (XPS) device (K-Alpha, manufactured by Thermo Fisher SCIENTIFIC). Tantalum (Ta), silicon (Si) and nitrogen (N) were 55 at%, 10 at% and 35 at%, respectively, based on the total of tantalum (Ta), silicon (Si) and nitrogen (N). The film was obtained as a film corresponding to an absorber film.

The obtained film was subjected to X-ray diffraction (XRD) measurement using an X-ray diffractometer (SmartLab, manufactured by Rigaku Co., Ltd.) to confirm the crystal phases contained in the film. None of β-TaN crystal phase, α-Ta crystal phase, and TaN crystal phase which is cubic phase was detected. Further, before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.41 µm in absolute value.

### Example 5

A reflective multilayer film was formed on a main surface of a low thermal expansion substrate (SiO₂-TiO₂-based glass substrate) having dimensions of 152 mm-square and 6.35 mm-thick in the same manner as in Example 1. Next, a protection film was formed on the reflective multilayer film in the same manner as in Example 1.

Next, an absorbent film was formed on the protection film in the same manner as in Reference Example 2. Before and after forming the absorber film, warpages (TIR) within a 142 mm-square at the center of the substrate surface was measured. An amount of change in warpage (ΔTIR) between the warpages (TIR) before and after forming the absorber film was calculated, and ΔTIR was 0.37 µm in absolute value.

## Claims

1. A reflective mask blank which is a material for a reflective mask used in EUV lithography in which EUV light is exposure light, comprising
a substrate,
a reflective multilayer film that is formed on one main surface of the substrate, has a periodically laminated structure in which layers having a comparatively low refractive index with respect to exposure light and layers having a comparatively high refractive index with respect to the exposure light are alternately laminated, and reflects the exposure light,
a protection film that is formed in contact with the reflective multilayer film, and
an absorber film that is formed in contact with the protection film, and absorbs the exposure light, wherein
the absorber film has a film stress of not more than a film stress in the case of forming the absorber film directly on the substrate.

2. The reflective mask blank of claim 1 wherein
the protection film consists of ruthenium (Ru), niobium (Nb) and oxygen (O), has a composition at the side close to the reflective multilayer film that comprises ruthenium (Ru) and is free of oxygen (O), and has a composition at the side in contact with the absorber film that consists of ruthenium (Ru), niobium (Nb) and oxygen (O), or niobium (Nb) and oxygen (O).

3. The reflective mask blank of claim 2 wherein the protection film has a composition at the side close to the reflective multilayer film that consists of ruthenium (Ru), or ruthenium (Ru) and niobium (Nb).

4. The reflective mask blank of claim 3 wherein in the protection film, the composition at the side close to the reflective multilayer film has a niobium (Nb) content of not more than 60 at%.

5. The reflective mask blank of claim 3 wherein the protection film has a niobium (Nb) content that stepwise and/or continuously increases along the thickness direction from the side close to the reflective multilayer film to the side in contact with the absorber film.

6. The reflective mask blank of claim 2 wherein in the protection film, the composition at the side close to the absorber film has a total content of niobium (Nb) and oxygen (O) of not less than 60 at%.

7. The reflective mask blank of claim 2 wherein the protection film has an oxygen (O) content that stepwise and/or continuously increases along the thickness direction from the side close to the reflective multilayer film to the side in contact with the absorber film.

8. The reflective mask blank of claim 1 wherein the protection film comprises a stress relaxing layer formed in contact with the absorber film.

9. The reflective mask blank of claim 8 wherein the protection film consists of two layers of
(A) a layer that has a composition comprising ruthenium (Ru), and being free of oxygen (O), and is close to the reflective multilayer film, and
(B) a layer that has a composition consisting of ruthenium (Ru), niobium (Nb) and oxygen (O), or niobium (Nb) and oxygen (O), and is in contact with the absorber film.

10. The reflective mask blank of claim 9 wherein the layer (A) consists of ruthenium (Ru), or ruthenium (Ru) and niobium (Nb).

11. The reflective mask blank of claim 10 wherein the layer (A) has a composition at the side close to the reflective multilayer film that has a content of niobium (Nb) of not more than 60 at%.

12. The reflective mask blank of claim 10 wherein
the layer (A) has two or more of sublayers that have different compositions each other, or is a compositionally graded layer, and
the layer (A) has a niobium (Nb) content that stepwise and/or continuously increases along the thickness direction from the side close to the reflective multilayer film to the side in contact with the layer (B).

13. The reflective mask blank of claim 9 wherein the layer (B) has a composition at the side close to the absorber film that has a total content of niobium (Nb) and oxygen (O) of not less than 60 at%.

14. The reflective mask blank of claim 9 wherein
the layer (B) has two or more of sublayers that have different compositions each other, or is a compositionally graded layer, and
the layer (B) has an oxygen (O) content that stepwise and/or continuously increases along the thickness direction from the side in contact with the layer (A) to the side in contact with the absorber film.

15. The reflective mask blank of claim 9 wherein
the protection film has a thickness of not less than 2 nm and not more than 5 nm, and
the layer (B) has a thickness of not less than 10% and not more than 50% of the thickness of the protection film.

16. The reflective mask blank of any one of claims 1 to 15 wherein the absorber film comprises tantalum (Ta) and nitrogen (N).

17. The reflective mask blank of claim 16 wherein
the absorber film further comprises one or more additive elements selected from the group consisting of hydrogen (H), boron (B), carbon (C), silicon (Si), molybdenum (Mo), zirconium (Zr), chromium (Cr), germanium (Ge) and aluminum (Al), and has a total content of the additive element(s) of not more than 20 at%.

18. The reflective mask blank of claim 16 wherein
the absorber film has a thickness of not less than 50 nm and not more than 80 nm,
the absorber film consists of a single layer consisting of tantalum (Ta) and nitrogen (N), or consists of a substrate-side layer consisting of tantalum (Ta) and nitrogen (N) and a surface-side layer consisting of tantalum (Ta), nitrogen (N) and oxygen (O),
each of the single layer, the substrate-side layer and the surface layer has a ratio Ta/N of tantalum (Ta) and nitrogen (N) of 55/45 to 65/35,
the surface-side layer has an oxygen (O) content of not less than 20 at% and not more than 40 at% at the side remotest from the substrate, and
the surface-side layer has a thickness of not more than 2 nm.
